# EUROPÄISCHE PATENTSCHRIFT

(11) **EP 2 070 869 B1**
(45) Veröffentlichungstag und Bekanntmachung des Hinweises auf die Patenterteilung: **05.10.2016**
(21) Anmeldenummer: 08020989.3
(22) Anmeldetag: 03.12.2008
(51) Int. Cl.: B81C 99/00, H01J 37/32

(54) **Vorrichtung und Verfahren zur Prozessierung von Mikrobauteilen**
Device and method of processing micro-components
Dispositif et procédé destinés au traitement de microcomposants

(30) Priorität: 12.12.2007 DE 102007059717
(43) Veröffentlichungstag der Anmeldung: 17.06.2009
(73) Patentinhaber: Muegge GmbH, 64385 Reichelsheim (Odenwald) (DE)
(72) Erfinder: Mathuni, Josef, 81737 München (DE)
(74) Vertreter: Tomerius, Isabel

(56) Entgegenhaltungen:
- DE-C1- 19 847 848
- US-A1- 2005 120 956
- US-A1- 2007 105 392
- US-A1- 2007 235 134
- US-B1- 6 352 870

## Beschreibung

Die Erfindung betrifft eine Vorrichtung zur Prozessierung von Mikrobauteilen mit Bauteilstrukturen, die auf einem Substrat beispielsweise nach dem LIGA-Verfahren generiert werden. Ferner betrifft die Erfindung ein Verfahren zur Prozessierung von Mikrobauteilen mit Bauteilstrukturen, bei welchem die Mikrobauteile an bereitgestellten Substraten generiert und anschließend von den sie umgebenden Materialbereichen befreit werden, indem die Materialbereiche weggeätzt (gestrippt) werden können.

Gattungsgemäße Vorrichtungen und Verfahren, mittels welchen Mikrobauteile zum Beispiel für die Uhrenindustrie hergestellt werden, sind aus dem Stand der Technik hinlänglich bekannt. Vermehrt werden hier Verfahren eingesetzt, die auf einer Kombination von Lithographie und Galvanik beruhen. Diese Verfahren sind im Allgemeinen als "LIGA"-Verfahren gut bekannt. Bei derartigen "LIGA"-Verfahren kann zunächst auf ein Substrat, beispielsweise Wafer oder dergleichen, eine Fotolackschicht aufgebracht werden. Als Fotolack kann ein Negativ-Lack mit der Bezeichnung SU-8 zur Anwendung kommen.

Bei dem Substrat kann es sich beispielsweise um einen Silizium-Wafer handeln, der an seiner Oberfläche eine dünne Goldschicht aufweist, an welcher Mikrobauteile besonders gut wachsen können. Auf diesen Silizium-Wafer wird die Fotolackschicht aufgetragen. Diese bedeckt insbesondere die Goldschicht und kann nun überall dort mittels eines geeigneten Belichtungssystems und einer Maske selektiv belichtet werden. Die unbelichteten Stellen der Fotolackschicht werden in einem anschließenden Entwicklungsschritt entfernt.

In einem daran anschließenden Galvanik-Verfahren kann man nun auf der so präparierten Substratoberfläche ein Metall, beispielsweise Nickel oder Gold, aufwachsen lassen, wobei das jeweilige Metall an den von der Fotolackschicht befreiten Stellen zu wachsen beginnt. Je nach vorgesehener Anwendung kann das Wachstum gestoppt werden, wenn gewachsene Metallstrukturen knapp über die Fotolackschicht hinauswachsen.

Der Fotolack SU-8 hat den Nachteil, dass die Entfernung von vernetzten SU-8-Strukturen zwischen galvanisch abgeschiedenen Metallstrukturen derzeit sehr aufwändig ist. SU-8 basiert auf Epoxydharz, welches im vernetzten Zustand sehr stabil gegenüber organische und anorganische Ätzmittel ist. Mittels bisher bekannter Ätzmittel wird der Fotolack entweder sehr langsam oder in der Art entfernt, dass die metallischen Mikrobauteile ebenfalls angegriffen und somit unbrauchbar werden.

Mechanisches Entfernen des Fotolacks vom Mikrobauteil verursacht nicht nur hohen Arbeitsund Kostenaufwand, sondern auch eine hohe Ausschussrate aufgrund der extrem kleinen Dimensionen der Mikrobauteile, wobei manche komplizierte Strukturformen unter diesen Voraussetzungen überhaupt nicht hergestellt werden können.

Herkömmliche Plasmaverfahren verlaufen zum einen sehr langsam, zum anderen wird auch das Metall von Ionen und Elektronen angegriffen. Der Ätzvorgang muss häufig unterbrochen werden, da die Substrate ansonsten zu heiß werden.

Bei bisherigen Verfahren wird mittels Emissions-Spektroskopie, die mit sehr hohen Kosten verbunden ist, das Ende des Strippvorgang, also der Fotolackentfernung, durch Messung der Intensität der Emissionslinie eines bestimmten Zersetzungsproduktes des Fotolacks festgestellt. Werden mehrere Mikrobauteile auf jeweiligen Substraten in einer Ätzkammer im sogenannten Batch-Betrieb vom Fotolack befreit, so war es nur möglich, den Beginn des Ätzvorgangs und das globale Ende des Ätzvorgangs zu erkennen. Es war jedoch nicht möglich, die einzelnen Substrate, die unterschiedlich dicke Fotolackschichten aufweisen können und somit unterschiedlich lange Strippzeiten benötigen, individuell zu überwachen. Ferner war es nicht möglich, rechtzeitig zu erkennen, ob ein individuelles Substrat beispielsweise aufgrund eines schlechten Kontakts zum Substrathalter, welcher auf einer Arbeitplatte aufliegt, zu heiß wird und somit beschädigt wird.

WO 2004/104704 A2 offenbart ein lithographisches Verfahren zur Herstellung von Mikrobauteilen. Hierbei wird versucht, konstruktiv Ätzkammern zu bilden, wodurch das Entfernen von SU-8 erleichtert werden soll. Es werden mehrere Zwischenschritte aufgrund von zusätzlichen Haftschichten, Stützstrukturen, Masken und Belichtungsschritten hinzugefügt, wodurch die Konstruktion und die Herstellung der Mikrobauteile aufwändiger werden.

Die US 2005/0120956 A1 offenbart eine Plasmaquelle für Ätzprozesse und befasst sich eingehender mit dem Problem, dass im Zusammenhang mit Plasmaquellen bzw. Plasmakammern ein Handling von Substraten unterschiedlicher Abmessungen Bearbeitungsprozesse insgesamt erschwert bzw. verlangsamt. Zur Lösung dieses Problems schlägt die Druckschrift eine speziell ausgebildete Bewegungsvorrichtung vor. Zudem offenbart sie die Verwendung eines gut haftenden und auch gut wärmeleitfähigen Materials, das zwischen einem Substrathalter und einem zu bearbeitendem Substrat aufgebracht wird.

Die US 2007/0325134 A1 ist auf ein Temperatursteuerungssystem und ein entsprechendes Verfahren gerichtet, die es erlauben, die Temperatur eines Substrates zonendefiniert zu steuern. Die Oberfläche eines Substrathalters wird auf eine vorbestimmte Temperatur gebracht, um auf diese Weise die Temperatur des Substrates zu steuern. Es wird ein Wärmetauscher offenbart, der eine Temperatur eines wärmeleitfähigen Fluides, das durch zwei oder mehr Kanäle fließt, gezielt anpassen kann. Zu diesem Zweck sind unterhalb eines Substrates in einen Substrathalter integriert zwei Sensoren vorgesehen, deren Messwerte für Steuerungszwecke verwendet werden. Es wird kein individueller Temperaturverlauf bestimmt, um das Ende eines Ätzvorganges genauer zu ermitteln.

US 6,352,870 B1 offenbart ein allgemeines Verfahren zur Bestimmung eines Endpunktes von Ätzprozessen, die auf einer Temperaturbestimmung des Substrates basiert. Mithilfe von Sensoren kann die Temperatur des Substrates bestimmt werden. Ein charakteristischer Temperaturverlauf während eines Ätzprozesses wird dabei zur Endpunktbestimmung des Ätzprozesses verwendet.

Aus all den oben aufgeführten Nachteilen des Standes der Technik, liegt der Erfindung die Aufgabe zugrunde, dass der Fotolack möglichst einfach, effizient und zuverlässig gestrippt werden soll, so dass der Ausschuss minimiert wird.

Die Aufgabe wird gelöst durch den Gegenstand der unabhängigen Patentansprüche. Abhängige Patentansprüche sind auf vorteilhafte Ausführungsformen gerichtet.

Die Einfachheit der Herstellung soll unter Nutzung und Kombination bereits bestehender Techniken und Anlagen mit möglichst wenigen, jedoch effektiven Zusatzschritten erreicht werden. Die Effizienz der Herstellung soll durch die Möglichkeit der gleichzeitigen Behandlung mehrerer Substrate in einer Ätzkammer und durch die Verkürzung der Strippdauer infolge einer erhöhten Abtragrate des Fotolacks gesteigert werden. Die Zuverlässigkeit der Herstellung und somit die Verringerung der Anzahl der beschädigten Mikrobauteile soll mit Hilfe von individueller Temperaturüberwachung, sowie der Absenkung der Substrattemperatur und der Vermeidung aggressiver Ätzmittel umgesetzt werden.

Im Rahmen der Erfindung wird der Fotolack mit einer gekühlten Remote-Plasmaquelle durch chemisches Ätzen kontrolliert gestrippt, wobei die Temperatur der Mikrobauteile individuell überwacht und der Temperaturverlauf einer Endpunktserkennung unterzogen wird.

Die Benutzung einer Remote-Plasmaquelle zum Strippen von Fotolack bietet den Vorteil, dass keine Ionen und Elektronen das Substrat erreichen und thermisch belasten. Die Radikale strippen den Fotolack über rein chemische Ätzen. Durch die Verwendung einer Mikrowellenquelle, wie z. B. von der Firma R3T GmbH wird die Radikalendichte erhöht. Eine geeignete Vorrichtung, mittels welcher insbesondere der vorstehend erläuterte Ätzvorgang gut durchgeführt werden kann, ist in der Patentschrift DE 198 47 848 C1 beschrieben. Die dort beschriebene Vorrichtung umfasst einen Generator zum Erzeugen von elektromagnetischen Wellen, wie etwa einen Mikrowellengenerator. Mittels der elektromagnetischen Wellen können in einer Plasmazone angeregte und/ oder ionisierte Teilchen gebildet werden. Zumindest die angeregten Teilchen werden mittels einer geeigneten Zuleitung in die Ätzkammer transportiert, um dort auf den Oberflächen der Substraten den gewünschte Ätzvorgang auslösen zu können. Da die Plasmakammer der Quelle mit einem Kühlmittel, beispielsweise Wasser, gekühlt ist, wird ein abgekühlter Radikal-Teilchenstrahl hoher Radikalendichte zum Strippen in die Ätzkammer eingeleitet, wodurch zum einen eine hohe Abtragrate, die mit der Radikalendichte ansteigt, erreicht und zum anderen die thermische Belastung der Substrate bis auf die unvermeidbare Reaktionswärme minimiert wird.

Für eine besonders vorteilhafte Ausführung der Erfindung werden zur individuellen Kontrolle der lokalen Substrattemperaturen über den gesamten Arbeitsbereich Thermosensoren verteilt. Diese werden in der Arbeitsplatte federnd gelagert, so dass ein mechanischer und somit thermischer Kontakt mit der Unterseite eines Substrathalters, auf dem sich ein Substrat befindet, sicher hergestellt ist. Es hat sich herausgestellt, dass aufgrund der in Echtzeit gemessenen Temperaturdaten, insbesondere an jedem Substrat, exakte Rückschlüsse auf den Fortschritt des Ätzvorgangs vorteilhafterweise an jedem der Substrate gezogen werden können.

Der Begriff "Substrat" beschreibt hierbei jegliche Gebilde, welche als Träger eingesetzt werden können, an denen die Mikrostrukturen wachsen können. Weit verbreitet sind hier Silizium-Wafer, die mit einer dünnen Goldschicht versehen werden können, wobei diese Goldschicht als Startschicht dient, von welcher aus Mikrostrukturen heranwachsen. Im vorliegenden Zusammenhang wird für den Begriff "Substrat" im Allgemeinen auch der Begriff Wafer synonym verwendet.

Mit "Substrathaltern" sind jegliche Gebilde gemeint, die den Kontakt zwischen den Substraten und der Arbeitsplatte herstellen können. Erfindungsgemäß wird auf ihrer Oberseite mittels Kontaktmittel ein Substrat angebracht und auf ihrer Unterseite befindet sich die Arbeitsplatte. Es wird erreicht, dass die Wärme von den Substraten, die aufgrund von Reaktionswärme heiß werden, über Kontaktmittel zum Substrathalter und von dort aus auf die Arbeitplatte weitergeleitet wird. Ferner dient ein Substrathalter zur horizontal ebenen Positionierung eines Substrats in einer Ätzkammer.

Als "Arbeitsplatte" eignen sich jegliche Einrichtungen, an welchen die bereitgestellten Substrate entweder mit oder ohne Substrathalter innerhalb der Ätzkammer angeordnet werden können. Idealerweise wird die Arbeitsplatte von einem Kühlmedium durchströmt, um so Prozesswärme aus der Ätzkammer abführen zu können.

Der Begriff "Ätzkammer" beschreibt jegliche Einrichtungen, in welchen die Herstellung der Mikrostrukturen vorgenommen werden kann. In einer solchen Kammer kann beispielsweise eine Fotolackschicht, von einer Substratoberfläche und/oder von einer Mikrostrukturoberfläche entfernt werden.

Mit dem Begriff "Kontaktmittel" sind jegliche Mittel beschrieben, welche dazu geeignet sind, den Kontakt zwischen den bereitgestellten Substraten und den Substrathaltern zu verbessern, so dass Temperaturunterschiede zwischen den bereitgestellten Substraten und der Arbeitsplatte besser ausgeglichen werden können als ohne derartige Kontaktmittel. Es versteht sich, dass solche Kontaktmittel in vielfältiger Weise realisiert werden können, solange ein besonders inniger Kontakt zwischen dem Substrat und dem Substrathalter hergestellt ist.

Erfindungsgemäß ermöglichen diese Kontaktmittel einen wesentlich besseren Kontakt zwischen den bereitgestellten Substraten und den Substrathaltern, so dass eine an den Substraten und/oder an den Mikrostrukturen vorhandene kritische Wärmeenergie wesentlich besser in die Arbeitsplatte abgeleitet werden kann, wodurch eine thermische Belastung der Substrate, insbesondere der Mikrostrukturen, vorteilhafter Weise erheblich reduzierbar ist. Hierdurch ist die Gefahr verringert bzw. idealerweise zur Gänze ausgeschlossen, dass die herzustellenden Mikrostrukturen aufgrund kritischer Temperaturverhältnisse beschädigt oder oftmals sogar unbrauchbar werden.

Wenn die Kontaktmittel Wachs umfassen, kann mittels des Wachses konstruktiv besonders einfach ein sehr intensiver Kontakt zwischen den bereitgestellten Substraten und den Substrathaltern erzielt werden. Zudem lässt sich der Wachs problemlos von den Substraten beziehungsweise von daran angewachsenen Mikrostrukturen entfernen, wenn beispielsweise ein Ätzprozess abgeschlossen wurde und die Mikrostrukturen von weiteren Verunreinigungen befreit werden sollen.

Mit Wachs als Kontaktmittel lassen sich kleine Unebenheiten auf der Substratunterseite und/ oder auf der Oberseite des Substrathalters, die auf eventuelle Herstellungsfehler oder unerwünschte Partikel zurückzuführen sind, sehr effektiv ausgleichen, so dass das Substrat horizontal eben ausgerichtet wird und einen optimalen Kontakt zum Substrathalter und somit zur Arbeitsplatte bekommt, wodurch ein günstiger thermischer Kontakt zur Wärmeabfuhr hergestellt wird.

Weiterhin besonders vorteilhaft ist es, zur individuellen Endpunktserkennung die individuell übermittelten Temperaturverläufe als Auswertekriterien zu verwenden. Die übermittelten Temperaturen steigen mit dem Beginn des Strippvorgangs von einer Ausgangstemperatur, beispielsweise Temperatur der Arbeitsplatte, aufgrund der Reaktionswärme auf das jeweilige Temperaturmaximum an und bleiben stabil, solange die Reaktion weiter stattfindet. Mit dem Ende des Strippvorgangs fangen die Temperaturen an, rasch zu sinken. Der Anfang, die Mitte, das Ende oder andere geeignete Stellen der abfallenden Flanke des individuellen Temperaturverlaufs wird als individueller Endpunkt des Strippvorgangs erkannt.

Idealerweise signalisiert eine Überwachungseinrichtung, welche beispielsweise ein Computer oder dergleichen sein kann und welche die von den Thermosensoren individuell übermittelten Temperaturen anzeigt und überwacht, das Ende des Strippvorgangs akustisch und/ oder visuell, so dass der Betreiber wahlweise das fertig gestrippte Mikrobauteil aus der Ätzkammer entnimmt oder wartet, bis weitere Mikrobauteile fertig gestrippt werden.

Weiterhin wäre es auch denkbar, die Überwachungseinrichtung derart auszuführen, dass der Strippvorgang automatisch gesteuert wird.

Gemäß einer bevorzugten Ausführungsform der Erfindung ist es so, dass eine Mikrowellenquelle zur Erhöhung der Radikalendichte außerhalb der Ätzkammer angeordnet ist.

Erfindungsgemäß ist die Plasmakammer außerhalb der Ätzkammer angeordnet und mit einem Kühlmedium gekühlt. Als Kühlmedium kommen beispielsweise Wasser oder andere Mittel in Frage, die die Wärme von der Plasmakammer abführen kön-

Bevorzugt kann in diesem Zusammenhang ein Remote-Plasmaverfahren eingesetzt werden, bei welchem das Plasma vorteilhafter Weise außerhalb einer Ätzkammer erzeugt wird und idealerweise keine Ionen und/oder Elektronen ein Substrat innerhalb der Ätzkammer erreichen. Vorteilhafter Weise angeordnet und mit einem Kühlmedium gekühlt. wird hierdurch das Substrat durch diese Ionen bzw. Elektronen zusätzlich nicht thermisch belastet. Insbesondere mit der eingangs beschriebenen Vorrichtung aus der Patentschrift DE 198 47 848 C1 kann ein bereits gekühlter Radikal-Teilchenstrahl mit einer hohen Radikalendichte gut bereit gestellt werden.

Besonders vorteilhaft ist die Anordnung der federgestützten Thermosensoren in der Arbeitsplatte unterhalb der Substratpositionen. Die Thermosensoren haben Kontakt mit der Unterseite des Substrathalters. Idealerweise wird jedem eingesetzten Substrat oder Substrathalter ein federgestützter Thermosensor zugeordnet. Hierdurch wird die individuelle Temperaturmessung und -überwachung eines jeden Substrats in Echtzeit ermöglicht.

Idealerweise wird eine Überwachungseinrichtung eingesetzt, die die von den Thermosensoren übermittelten Temperaturen in Echtzeit individuell anzeigen und mittels geeigneter Kriterien überwachen. Die Überwachung umfasst die Endpunktserkennung und die Signalisierung der Beendigung der Strippvorgänge. Ferner soll überwacht werden, ob ein Strippvorgang nach einem vorgegebenen Schema abläuft. Treten Störungen auf, z. B. Überhitzung eines Substrats, so signalisiert die Überwachungseinrichtung diese Störung und leitet geeignete Maßnahmen ein, so dass das Substrat nicht beschädigt wird.

Weiterhin vorteilhaft ist die Anordnung einer Überwachungseinrichtung an einem Ort, die nicht unbedingt in der Nähe der Plasmakammer sein muss. So kann der Betreiber beispielsweise bequem vom seinem Büro aus den Strippvorgang in Echtzeit mitverfolgen. Bei einer Signalisierung eines beendeten Strippvorgangs über die Überwachungseinrichtung kann er sich entscheiden, ob dieses fertige Mikrobauteil aus der Ätzkammer entnommen wird oder nicht.

Aus den vorher erläuterten Vorteilen eignet sich somit die Verwendung der beschriebenen Vorrichtung und Verfahren sehr gut zum Strippen von Fotolack für Mikrobauteile mit Bauteilstrukturen.

Nachfolgend wird die Erfindung anhand eines in den Zeichnungen dargestellten Ausführungsbeispiels weiter beschrieben. Es zeigen schematisch:
- Figur 1: eine geschnittene, vergrößerte Ansicht eines nach LIGA-Verfahren hergestellten Mikrobauteils auf einem Substrat
- Figur 2: eine geschnittene Ansicht einer Vorrichtung zur Herstellung von Mikrobauteilen
- Figur 3: eine Detailansicht der Arbeitsplatte aus der Figur 2, und
- Figur 4: eine beispielhafte Visualisierung von drei Temperaturverläufen dreier Substrate.

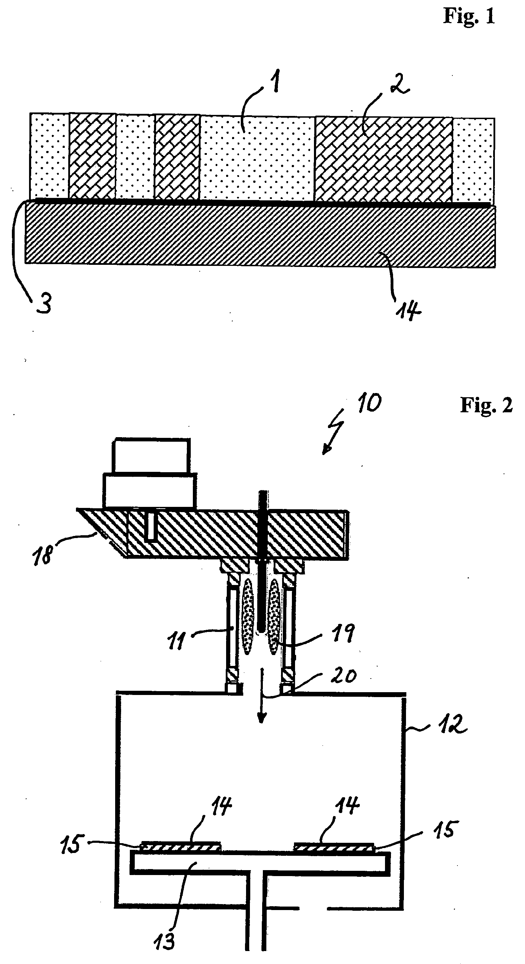

In der Figur 1 ist ein nach LIGA-Verfahren hergestelltes Mikrobauteil auf einem Substrat 14 dargestellt. Der Fotolack 1 umgibt das galvanisch auf einer Goldschicht 3, die als Startschicht dient, abgeschiedene Metall 2.

Die in der Figur 2 gezeigte Vorrichtung 10 zur Herstellung von Mikrostrukturen (hier nicht gezeigt) umfasst eine Ätzkammer 12, in welcher eine thermostatisierte Arbeitsplatte 13 angeordnet ist.

Außerhalb der Ätzkammer 12 ist eine Mikrowellenquelle 18 angeordnet. Ferner ist eine wassergekühlte Plasmakammer 11 dargestellt, die sich ebenfalls außerhalb der Ätzkammer 12 befindet. Mittels der Mikrowellenquelle 18 kann in der wassergekühlten Plasmakammer 11 gekühltes Remote-Plasma 19 erzeugt werden. Auf eine detaillierte Beschreibung, wie das vorliegende Remote-Plasmaverfahren im Einzelnen funktioniert, wird vorliegend verzichtet, da es sich bei dem Remote-Plasmaverfahren um ein gut bekanntes Verfahren handelt. Eine diesbezüglich geeignete Vorrichtung und diesbezüglich geeignete Verfahren sind auch in der eingangs erwähnten Patentschrift DE 198 47 848 C1 gut beschrieben.

Vorliegend wird vorteilhafter Weise das erzeugte Remote-Plasma 19 bereits mittels der wassergekühlten Plasmakammer 11 gekühlt, so dass hierdurch bereits eine vorteilhafte Temperaturreduzierung hinsichtlich des noch zu erläuternden Ätzverfahrens realisiert werden kann.

Das vorliegende Remote-Plasmaverfahren kann mittels der hier dargestellten Vorrichtung 10 derart gesteuert werden, dass ein gekühlter Radikalen-Teilchenstrahl 20 mit einer besonders hohen Radikalendichte in die Ätzkammer 12 gelangt.

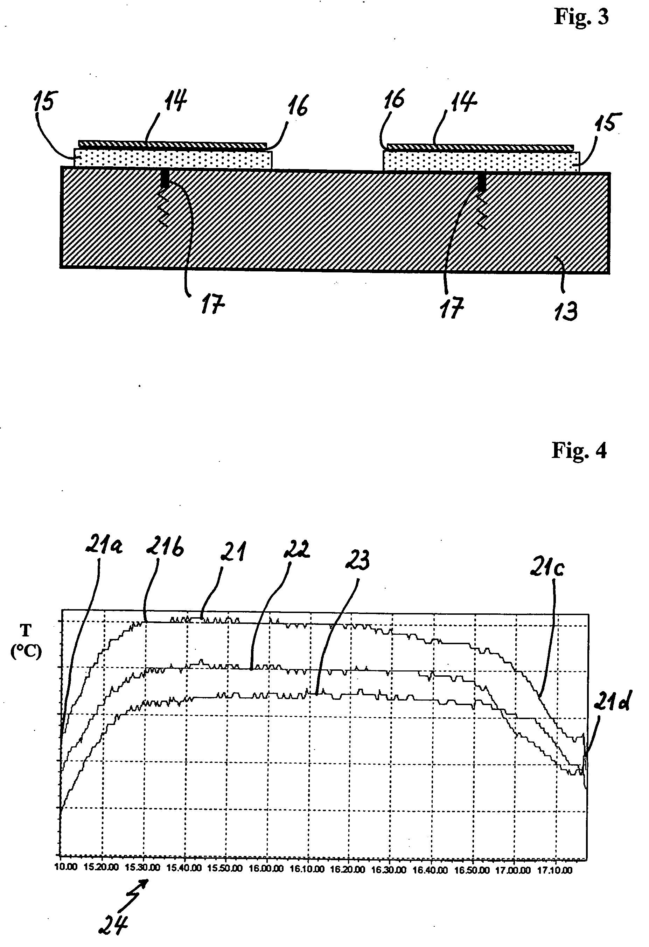

Wie auch hauptsächlich aus der Darstellung nach Figur 3 ersichtlich ist, sind auf einer thermostatisierten Arbeitsplatte 13 Substrate 14 angeordnet. In den geschnittenen Ansichten dieses konkreten Ausführungsbeispiels sind zwei Substrate 14 mittels zweier Substrathalter 15 auf der Arbeitsplatte 13 aufgelegt. Mittels der Substrathalter 15 kann Reaktionswärme, welche beispielsweise bei einem Ätzprozess entsteht, bei welchem nicht mehr erforderliche Materialbereiche (hier nicht dargestellt), wie etwa eine Fotolackschicht SU-8, von den Substraten 14 weggeätzt werden, besonders vorteilhaft von den Substraten 14 abgeleitet werden. Dieses Ableiten der Reaktionswärme gelingt besonders gut, wenn die beiden Substrathalter 15 aus einem thermisch gut leitenden Material hergestellt sind. Damit der Wärmeübergang von den gezeigten Substraten 14 vollflächig auf die Substrathalter 15 erzielt werden kann, ist zwischen den Substraten 14 und den jeweiligen Substrathaltern 15 jeweils ein Kontaktmittel 16 (siehe insbesondere Figur 3) angeordnet. Die Kontaktmittelschichten dienen auch zur horizontal ebenen Positionierung der Substrate 14 auf den Substrathaltern 15 in der Ätzkammer 12. Bei diesem Ausführungsbeispiel ist das Kontaktmittel 16 aus Wachs.

Mittels der Wachsschichten sind die Substrate 14 fest aber lösbar und einzeln über den jeweiligen Substrathaltern 15 positioniert. Sowohl die Wachsschichten als auch die Substrathalter 15 stellen im Sinne der Erfindung insbesondere Mittel zum vollflächigen Auflegen der bereitgestellten Substrate 14 auf der thermostatisierte Arbeitsplatte 13 dar.

Mittels der Wachsschichten gelingt es besonders gut, die bereits erwähnte Reaktionswärme von den Substraten 14 und damit auch von den herzustellenden Mikrostrukturen (hier nicht explizit gezeigt) abzuleiten, so dass insbesondere auch die Mikrostrukturen thermisch weniger belastet werden, wodurch wiederum der Ausschuss der Mikrostrukturen vorteilhafter Weise verringert werden kann.

Darüber hinaus sind in der thermostatisierten Arbeitsplatte 13 federgestützte Thermosensoren 17 vorgesehen, mittels welchen die vorhandenen Temperaturen unmittelbar an den Substrathaltern 15 erfasst werden können.

Vorteilhafter Weise gelingt es hierdurch, ein Monitoring der tatsächlich vorhandenen Temperaturen unmittelbar an den Substrathaltern 15 und damit auch an den Substraten 14 beziehungsweise auch an jeweiligen Mikrostrukturen zu realisieren.

Vorzugsweise sind hierzu jedem Substrathalter 15 beziehungsweise jedem Substrat 14, die an der Arbeitsplatte 13 angeordnet sind, jeweils ein Thermosensor 17 zugeordnet. So kann betriebssicher und dauerhaft gewährleistet werden, dass jeder der vorhandenen Thermosensoren 17 mit dem zugehörigen Substrathalter 15 in Wirkkontakt stehen kann.

Sind die Thermosensoren 17 wie in der Fig. 3 federgestützt bzw. federnd gelagert, so kann besonders gut sichergestellt werden, dass die Thermosensoren 17 stets mit ausreichenden Kräften gegen die Substrathalter 15 gedrückt werden.

Da, wie bereits vorstehend beschrieben, ein direkter Zusammenhang zwischen den anliegenden Temperaturen an den Substraten 14 und dem Vorhandensein von noch wegzuätzendem Fotolack besteht, können anhand der ermittelten Temperaturdaten Rückschlüsse darauf gezogen werden, inwieweit ein Ätzvorgang an einem der Substrate 14 bereits fortgeschritten ist. Insbesondere kann auf Grund einer rasch fallenden Temperatur während des Ätzvorgangs erkannt werden, ob ein Ätzvorgang an einem der Substrate 14 bereits beendet ist, da dann an diesem Substrat keine Reaktionswärme erzeugt wird.

Um die mittels der Thermosensoren 17 erfassten Temperaturdaten entsprechend auswerten zu können, ist es vorteilhaft, wenn die vorliegende Vorrichtung 10 über eine geeignete Überwachungseinrichtung verfügt, welche eine Möglichkeit zur Visualisierung der erfassten Temperaturdaten mittels Anzeigemittel 24 aufweist.

Im vorliegenden Beispiel sind an dem Anzeigemittel 24 eine erste Temperaturkurve 21 eines Substrats 14, eine zweite Temperaturkurve 22 eines anderen Substrats 14 und eine dritte Temperaturkurve 23 eines dritten, hier nicht gezeigten Substrats optisch dargestellt.

Die Temperaturkurven 21, 22 und 23 zeigen die jeweiligen Temperaturen an den entsprechenden Substraten 14 über einen bestimmten Zeitraum an. Anhand der ersten Temperaturkurve 21 wird beschrieben, in welcher Phase sich das erste Substrat 14 befindet. Zu Beginn des Ätzvorgang weist das Substrat 14, an welcher der erste federgestützte Thermosensor 17 angeordnet ist, eine Ausgangstemperatur 21a auf, die nahe der Temperatur der thermostatisierten Arbeitplatte ist. Mit dem Einsetzen des Strippvorgangs steigt die Temperatur an dem Substrat 14 auf eine Gleichgewichtstemperatur 21 b an. Die Gleichgewichtstemperatur stellt sich ein, wenn der zur Arbeitsplatte 13 hin entstehende Temperaturgradient die Reaktionswärme vom Substrat 14 gerade ableitet. Die Gleichgewichtstemperatur bleibt nahe zu konstant, so lange der Strippvorgang an diesem Substrat 14 erfolgt. Ist das Substrat 14 vom Fotolack befreit, so beginnt die Temperatur zu sinken. Der Beginn, die Mitte, das Ende oder andere geeignete Stellen der abfallenden Flanke des Temperaturverlaufs können als Endpunkt des Strippvorgangs 21c erkannt werden. Durch die geeignete Einstellung der Endpunktserkennung ist somit die Möglichkeit zur Einstellung einer optimalen Ätzdauer gegeben.

Mittels der vorliegenden Vorrichtung können zu jedem der Substrate 14 unterschiedliche Temperaturen und unterschiedliche Temperaturverläufe 21, 22, 23 angezeigt werden, so dass eine Beurteilung des jeweils ablaufenden Ätzvorgangs an dem jeweiligen Substrat 14 schnell und sicher vorgenommen werden kann. Gründe für die unterschiedlichen Temperaturverläufe können unterschiedlich ablaufende Reaktionen an dem jeweiligen Substrat 14 sein, die auf unterschiedlich dicke Lackschichten hinweisen können.

## Patentansprüche

1. Verfahren zur Prozessierung von Mikrobauteilen mit Bauteilstrukturen, die auf einem Substrat (14) erzeugt sind, beispielsweise unter Verwendung des LIGA-Verfahrens, wobei die Mikrobauteile in einer Ätzkammer (12) von auf Epoxydharz basiertem Fotolack befreit werden,
**dadurch gekennzeichnet,**
**dass** der Fotolack mit einer gekühlten Remote-Plasmaquelle durch chemisches Ätzen kontrolliert gestrippt wird, wobei die Temperaturen der Mikrobauteile individuell überwacht und die Temperaturverläufe (21, 22, 23) einer individuellen Endpunktserkennung unterzogen werden, und
**dass** das Substrat (14) mit Hilfe eines Kontaktmittels (16), beispielsweise mit Wachs, auf einen Substrathalter (15), der auf einer thermostatisierten Arbeitsplatte (13) eben aufliegt, plan angedrückt und nach dem Ende des Strippvorgangs wieder getrennt wird, wodurch die Reaktionswärme während des Strippvorgangs vom Substrat (14) auf den Substrathalter (15) und von dort über seine Unterseite auf die thermostatisierte Arbeitsplatte (13) abgeführt wird, so dass das Substrat (14) nicht infolge der thermischen und mechanischen Belastung beschädigt wird.

2. Verfahren nach Anspruch 1,
**dadurch gekennzeichnet,**
**dass** die individuelle Temperaturmessung in Echtzeit über Thermosensoren (17) erfolgt, die über die thermostatisierte Arbeitsplatte (13) verteilt unterhalb der Positionen der Mikrobauteile im mechanischen Kontakt sind mit dem Substrathalter (15), auf dem sich das Substrat (14) befindet.

3. Verfahren nach einem der Ansprüche 1 bis 2,
**dadurch gekennzeichnet,**
**dass** zur individuellen Endpunktserkennung die individuell übermittelten Temperaturverläufe (21, 22, 23) als Auswertekriterien verwendet werden, wobei die Temperatur mit dem Beginn des Strippvorgangs von einer Ausgangstemperatur aufgrund der Reaktionswärme infolge der Reaktion des Fotolacks mit den Radikalen auf eine Gleichgewichtstemperatur ansteigt und stabil bleibt, solange die Reaktion stattfindet, und mit dem Ende des Strippvorgangs auf eine Endtemperatur abfällt, wodurch die Endpunktserkennung mit der abfallenden Flanke des Temperaturverlaufs verknüpft ist.

4. Verfahren nach einem der Ansprüche 1 bis 3,
**dadurch gekennzeichnet,**
**dass** die Dichte der Radikale im Plasma (19) mit Hilfe einer externen Mikrowellenquelle (18) zugunsten einer höheren Abtragrate des Fotolacks erhöht wird.

5. Verfahren nach einem der Ansprüche 1 bis 4,
**dadurch gekennzeichnet,**
**dass** eine externe Plasmakammer (11) zur Bereitstellung des Remote-Plasmas zugunsten einer geringeren thermischen Belastung der sich in einer Ätzkammer (12) befindlichen Mikrobauteile mit Kühlmittel gekühlt wird, wodurch die bereits vom Fotolack befreiten Mikrobauteile problemlos in der Ätzkammer (12) bleiben können, bis anhand der individuell übermittelten Temperaturverläufe (21, 22, 23) das Ende aller Strippvorgänge erkannt und somit der Ätzvorgang rechtzeitig beendet wird.

6. Verfahren nach einem der Ansprüche 1 bis 5,
**dadurch gekennzeichnet,**
**dass** die individuelle Endpunktserkennung das Ende jedes Strippvorgangs über eine Anzeige (24) einer Überwachungseinrichtung signalisiert, so dass wahlweise das jeweilige fertig gestrippte Mikrobauteil aus der Ätzkammer (12) entnommen wird.

7. Vorrichtung (10) zur Prozessierung von Mikrobauteilen mit Bauteilstrukturen, die auf einem Substrat (14) erzeugt sind, beispielsweise unter Verwendung des LIGA-Verfahrens, nach einem Verfahren gemäß einem der Ansprüche 1 bis 6, umfassend eine Ätzkammer (12), die ausgebildet ist, um die Bauteilstrukturen von auf Epoxydharz basiertem Fotolack zu befreien, und eine außerhalb der Ätzkammer (12) angeordnete und mit einem Kühlmittel gekühlte Plasmakammer (11),
**dadurch gekennzeichnet, dass** sie weiter umfasst:
- einen Substrathalter (15), der auf einer thermostatisierten Arbeitsplatte (13) eben aufliegt und mit einer Schicht eines Kontaktmittels (16), beispielsweise Wachs, versehen ist, um das Substrat (14) lösbar auf dem Substrathalter (15) zu positionieren und einen vollflächigen Wärmeübergang vom Substrat (14) auf den Substrathalter (15) zu erzielen,
- mindestens ein Thermosensor (17), der in der thermostatisierten Arbeitsplatte (13) unterhalb der Positionen der Mikrobauteile unter dem Substrathalter (15) angeordnet ist, auf dem sich das Substrat (14) befindet, und
- eine Überwachungseinrichtung, die ausgebildet ist, um von den Thermosensoren (17) individuell übermittelte Temperaturverläufe (21, 22, 23) anzuzeigen und die Endpunkte der Strippvorgänge individuell zu überwachen und zu signalisieren.

8. Vorrichtung (10) zur Herstellung von Mikrobauteilen mit Bauteilstrukturen gemäß Anspruch 7, **dadurch gekennzeichnet,**
**dass** sie mehrere Substrathalter (15) umfasst, auf denen jeweils ein Substrat (14) angeordnet ist, wobei jedem Substrat (14) ein Thermosensor (17) zugeordnet ist.

9. Vorrichtung (10) zur Herstellung von Mikrobauteilen mit Bauteilstrukturen gemäß Anspruch 7 oder 8, **dadurch gekennzeichnet,**
**dass** eine Mikrowellenquelle (18) zur Erhöhung der Dichte der Radikale außerhalb der Ätzkammer (12) angeordnet ist.

## Claims

1. A method for processing microcomponents with component structures which are produced on a substrate (14) by using, for example, the LIGA method, wherein an epoxy resin based photoresist is removed from the microcomponents in an etching chamber (12),
**characterized in that**
the photoresist is stripped in a controlled manner with a cooled remote plasma source by chemical etching, the temperatures of the microcomponents being monitored individually and the temperature curves (21, 22, 23) being subjected to an individual end point recognition, and
that the substrate (14) is pressed in a planar manner with the help of a contact means (16) such as, for example, wax onto a substrate holder (15) resting in a planar manner on a thermostatized work plate (3) and is separated again after the end of the stripping process, whereby the reaction heat is dissipated during the stripping process from the substrate (14) to the substrate holder (15) and from there via its bottom side to the thermostatized work plate (13), so that the substrate (14) is not damaged as a result of the thermal and mechanical stress.

2. The method according to claim 1,
**characterized in that**
the individual temperature measurement is performed in real time via thermal sensors (17) which are distributed over the thermostatized work plate (13) and, underneath the positions of the microcomponents, are in mechanical contact with the substrate holder (15) on which the substrate (14) is disposed.

3. The method according to any one of claims 1 to 2,
**characterized in that**
the individually transmitted temperature curves (21, 22, 23) are used as evaluation criteria for the individual end point recognition, the temperature rising with the start of the stripping process from an initial temperature as a result of the reaction heat due to the reaction of the photoresist with the radicals to an equilibrium temperature and remaining stable as long as the reaction occurs and decreasing with the end of the stripping process to an end temperature, whereby the recognition of the end point is linked to the decreasing flank of the temperature curve.

4. The method according to any one of claims 1 to 3,
**characterized in that**
the density of the radicals in the plasma (19) is increased with the help of an external microwave source (18) for the benefit of a higher photoresist removal rate.

5. The method according to any one of claims 1 to 4,
**characterized in that**
an external plasma chamber (11) for providing the remote plasma is cooled with a coolant for the benefit of lower thermal loading of the microcomponents disposed in an etching chamber (12), whereby the microcomponents already freed of photoresist can easily remain in the etching chamber (12) until the end of all stripping processes is recognized on the basis of the individually transmitted temperature curves (21, 22, 23) and the etching process is thus terminated in due time.

6. The method according to any one of claims 1 to 5,
**characterized in that**
the individual end point recognition signalizes the end of each stripping process via a display (24) of a monitoring device, so that the respectively finished stripped microcomponent is optionally removed from the etching chamber (12).

7. An apparatus (10) for processing microcomponents with component structures which are produced on a substrate (14) by using, for example, the LIGA method, according to the method of any one of claims 1 to 6,
comprising an etching chamber (12) configured to remove epoxy resin based photoresist from the component structures, and a plasma chamber (11) which is arranged outside the etching chamber (12) and is cooled with a coolant,
**characterized in that** it further comprises:
- a substrate holder (15) which rests in a planar manner on a thermostatized work plate (13) and has a contact means (16) layer such as, for example, wax applied to it in order to detachably position the substrate (14) on the substrate holder and to achieve a heat transfer from the substrate (14) to the substrate holder (15) over the full surface area,
- at least one thermal sensor (17), which is arranged in the thermostatized work plate (13) underneath the positions of the microcomponents beneath the substrate holder (15) on which the substrate (14) is disposed, and
- a monitoring device configured to display temperature curves (21, 22, 23) individually transmitted from the thermal sensors and to individually monitor and signalize the end points of the stripping processes.

8. The apparatus (10) for producing microcomponents with component structures according to claim 7,
**characterized in that**
it comprises multiple substrate holders (15) on which in each case a substrate (14) is arranged, a thermal sensor (17) being assigned to each substrate (14).

9. The apparatus (10) for producing microcomponents with component structures according to claim 7 or 8,
**characterized in that**
a microwave source (18) for increasing the density of the radicals is arranged outside the etching chamber (12).

## Revendications

1. Procédé pour le traitement de microcomposants avec des structures de composants qui sont produites sur un substrat (14) en utilisant, par exemple, le procédé LICA, dans lequel une laque photosensible à base de résine époxyde est retirée des microcomposants dans une chambre de gravure (12),
**caractérisé en ce que**
la laque photosensible est décapée de manière contrôlée avec une source de plasma distante refroidie par gravure chimique, les températures des microcomposants étant contrôlées individuellement et les courbes de températures (21, 22, 23) étant soumises à une reconnaissance du point final individuel, et
**en ce que** le substrat (14) est pressé de manière plane avec l'aide d'un moyen de contact (16) tel que, par exemple, de la cire sur un porte-substrat (15) reposant de manière plane sur une plaque de travail thermostatée (13), et il en est séparé à nouveau après la fin du processus de décapage, la chaleur réactionnelle étant dissipée pendant le processus de décapage du substrat (14) vers le porte-substrat (15) et, de là, par l'intermédiaire de sa face inférieure, vers la plaque de travail thermostatée (13), si bien que le substrat (14) n'est pas endommagé par la contrainte thermique et mécanique.

2. Procédé selon la revendication 1,
**caractérisé en ce que**
la mesure individuelle de température est effectuée en temps réel grâce à des capteurs thermiques (17) qui sont répartis sur la plaque de travail thermostatée (13) et, sous les positions des microcomposants, sont en contact mécanique avec le porte-substrat (15) sur lequel le substrat (14) est disposé.

3. Procédé selon l'une quelconque des revendications 1 à 2,
**caractérisé en ce que**
les courbes de températures (21, 22, 23) transmises individuellement sont utilisées comme critère d'évaluation pour la reconnaissance du point final individuel, la température s'élevant avec le début du processus de décapage d'une température initiale en résultat de la chaleur réactionnelle due à la réaction de la laque photosensible avec les radicaux jusqu'à une température d'équilibre, et demeurant stable aussi longtemps que se produit la réaction, et diminuant avec la fin du processus de décapage jusqu'à une température finale, la reconnaissance du point final étant liée au flanc décroissant de la courbe de température.

4. Procédé selon l'une quelconque des revendications 1 à 3,
**caractérisé en ce que**
la densité des radicaux dans le plasma (19) est augmentée avec l'aide d'une source de micro-ondes externe (18) au bénéfice d'un taux de retrait supérieur de la laque photosensible.

5. Procédé selon l'une quelconque des revendications 1 à 4,
**caractérisé en ce que**
une chambre à plasma externe (11) pour la fourniture du plasma distant est refroidie avec un réfrigérant au bénéfice d'une charge thermique inférieure des microcomposants disposés dans une chambre de gravure (12), ce qui fait que les microcomposants déjà libérés de la laque photosensible peuvent sans problème demeurer dans la chambre de gravure (12) jusqu'à ce que la fin de tous les processus de décapage soit reconnue sur la base des courbes de températures transmises individuellement (21, 22, 23) et que le processus de gravure soit ainsi terminé à temps.

6. Procédé selon l'une quelconque des revendications 1 à 5,
**caractérisé en ce que**
la reconnaissance du point final individuel signale la fin de chaque processus de décapage par l'intermédiaire d'un affichage (24) d'un dispositif de contrôle, de sorte que le microcom-posant décapé terminé respectif soit éventuellement retiré de la chambre de gravure (12).

7. Dispositif (10) pour le traitement de microcomposants avec des structures de composants qui sont produites sur un substrat (14) en utilisant, par exemple, le procédé LIGA, selon le procédé de l'une quelconque des revendications 1 à 6,
comprenant une chambre de gravure (12) configurée pour retirer une laque photosensible en résine époxyde des structures de composant, et une chambre à plasma (11) qui est disposée à l'extérieur de la chambre de gravure (12) et est refroidie avec un réfrigérant, **caractérisé en ce qu'**il comprend en outre:
- un porte-substrat (15) qui repose de manière plane sur une plaque de travail thermostatée (13) et possède une couche d'un moyen de contact (16) tel que, par exemple, de la cire appliquée sur lui de manière à positionner de manière libérable le substrat (14) sur le porte-substrat et à obtenir un transfert thermique du substrat (14) au porte-substrat (15) sur toute la zone de surface,
- au moins un capteur thermique (17), qui est disposé dans la plaque (13) de travail thermostatée, en-dessous des positions des microcomposants sous le porte-substrat (15) sur lequel le substrat (14) est disposé, et
- un dispositif de contrôle configuré pour afficher les courbes de température (21, 22, 23) transmises individuellement par les capteurs thermiques et pour surveiller individuellement et signaler les points finaux des processus de décapage.

8. Dispositif (10) pour la production de microcomposants avec des structures de composants selon la revendication 7,
**caractérisé en ce que**
il comprend une pluralité de porte-substrats (15) sur lesquels, respectivement, un substrat (14) est disposé, un capteur thermique (17) étant assigné à chaque substrat (14).

9. Dispositif (10) pour la production de microcomposants avec des structures de composants selon la revendication 7 ou 8,
**caractérisé en ce que**
une source de micro-ondes (18) pour augmenter la densité des radicaux est disposée à l'extérieur de la chambre (12) de gravure.
